Europäisches Patentamt

European Patent Office

Office européen des brevets

(11) Veröffentlichungsnummer: **0 025 964**

**A1**

(12) **EUROPÄISCHE PATENTANMELDUNG**

(21) Anmeldenummer: 80105517.9

(51) Int. Cl.³: **H 03 F 1/52**

(22) Anmeldetag: 13.09.80

(30) Priorität: 19.09.79 DE 2937780

(43) Veröffentlichungstag der Anmeldung:
01.04.81 Patentblatt 81/13

(84) Benannte Vertragsstaaten:
AT BE CH DE FR GB IT LI LU NL SE

(71) Anmelder: Licentia Patent-Verwaltungs-GmbH
Theodor-Stern-Kai 1
D-6000 Frankfurt/Main 70(DE)

(72) Erfinder: Karbowski, Georg, Dipl.-Ing.
Lettow-Vorbeck-Allee 91
D-3000 Hannover 91(DE)

(74) Vertreter: Einsel, Robert, Dipl.-Ing.
Theodor-Stern-Kai 1
D-6000 Frankfurt/Main 70(DE)

(54) Elektronische Sicherung für Endverstärker mit MOS-FET-Endtransistoren.

(57) Elektronische Sicherung für Endverstärker mit MOS-FET-Endtransistoren (entsprechend P 29 37 780.8)

Die Erfindung bezieht sich auf eine elektonische Sicherung in Endstufen mit Feldeffekt-Transistoren (9,22). Während bei bipolaren Transistoren als Kriterium für den Überlastungsfall ein an einem Emitter-Widerstand auftretender Spannungsabfall dient, wird bei der erfindungsgemäßen Schaltung die Gate-Source-Spannung ($U_G$) als Kriterium für die Größe des Drain-Stromes ($I_D$) verwendet.

EP 0 025 964 A1

0025964

Licentia Patent-Verwaltungs-GmbH
Theodor-Stern-Kai 1

6000 Frankfurt/Main 70

Hannover, den 11.09.1979
UE2-Kör/gn

Elektronische Sicherung für Endverstärker mit MOS-FET-
Endtransistoren
_____

In hochwertigen Leistungsverstärkern werden anstelle der bisher üblichen bipolaren Endtransistoren zunehmend MOS-FET-
Endtransistoren verwendet. Derartig aufgebaute Endstufen sind
den konventionellen Endstufen mit bipolaren Transistoren hinsichtlich geringer nichtlinearer Verzerrungen überlegen. Bei
MOS-FET-Endstufen können sogar die bei Endstufen mit bipolaren Transistoren üblichen Emitter-Widerstände, die eine
Gegenkopplung und damit Linearisierung des Steuerverhaltens
der Transistoren bewirken sollen, entfallen. Für den Einbau
einer elektronischen Sicherung, die bei Kurzschluß der Lautsprecherleitung oder bei zu kleinem Lautsprecherwiderstand
die Endtransistoren vor Überlastung schützen soll, besteht
die Schwierigkeit, ein eindeutiges Kriterium für den Überlastungsfall zu finden. Dieses Kriterium bestand bei bipolaren Transistoren unter anderem in einer Messung des
Kollektorstromes des Endtransistors über den Spannungsabfall
an dem bereits erwähnten Emitter-Widerstand. Diese Meßmethode läßt sich jedoch nicht in analoger Weise auf FET-
Endstufen übertragen, da vergleichbare Source-Widerstände
nicht vorhanden sind.

Die der Erfindung zugrunde liegende Aufgabe besteht deshalb
darin, eine elektronische Sicherung für Endverstärker mit
MOS-FET-Endtransistoren zu schaffen, die die speziellen
Gegebenheiten der Schaltungstechnik einer solchen Endstufe
berücksichtigt. Diese Aufgabe wird bei einer Schaltung gemäß dem Oberbegriff des Patentanspruchs 1 durch die im
Kennzeichen angegebenen Merkmale gelöst. Weiterbildungen
und vorteilhafte Ausführungsformen sind in den Unteransprüchen angegeben.

Bei einem Endverstärker mit MOS-FET-Endtransistoren ist die
Gefahr einer Überlastung der Transistoren bei Kurzschluß
der Lautsprecherleitung besonders groß, da keine Strombegrenzung durch Source-Widerstände erfolgt, sondern vielmehr
der Strom durch den Widerstand der Source-Drain-Strecke bestimmt wird und die gesamte Verlustleistung im Transistor
selbst entsteht. Da der durch die Source-Drain-Strecke
fließende Strom nicht über einen Spannungsabfall an einem in
diesem Stromkreis angeordneten Widerstand gemessen werden
kann, muß untersucht werden, ob die Strommessung auf andere
Weise möglich ist. Aus der Schaltungstechnik mit bipolaren
Transistoren weiß man, daß der Steuerstrom, in diesem Fall
der Basis-Strom, weitgehend ein Maß für den Kollektor-Strom
darstellt. Die dabei auftretenden Stromstärken sind aber
sehr gering und die Erkennungsschaltung für den Kurzschluß -
fall müßte hochohmig aufgebaut werden. Außerdem ist kein
ausreichend definierter Zusammenhang zwischen Basis-Strom
und Kollektor-Strom gegeben, weil die Stromverstärkung in
Abhängigkeit vom Kollektor-Strom, von der Temperatur und vor
allen Dingen von Exemplar zu Exemplar sehr stark streut. Bei
Feldeffekttransistoren fließt dagegen gar kein Gate-Strom, so
daß die für bipolare Transistoren denkbare Ausweichmöglichkeit hier nicht in Betracht kommt. Eine andere Möglichkeit,
nämlich die Steuerspannung, in diesem Fall die Änderung der
Emitter-Basis-Spannung, als Maß für den Kollektor-Strom bei
bipolaren Transistoren zu verwenden, ist praktisch untauglich, da sich die Steuerspannung oberhalb der Anlaufspannung von etwa 0,7 V kaum noch ändert. Es besteht daher zunächst ein Vorurteil von der Schaltungstechnik mit bipolaren Transistoren her, die Steuerspannung als brauchbares Kriterium für den Überlastungsfall bei einer FET-Endstufe zu untersuchen. Bei der vorliegenden Erfindung wurde dieser Weg trotzdem beschritten. Es hat sich gezeigt, daß bei MOS-Feldeffekt-Leistungstransistoren oberhalb einer gewissen Source-Drain-Spannung der Drain-Strom praktisch nur noch von der Gate-Spannung bestimmt wird und die Unterschiede der Steuerkennlinien $I_{Drain} = f_{(U_{Gate})}$ von Exemplar zu Exemplar sehr gering sind. Da außerdem der Bereich der Steuerkennlinie, in dem die Aussteuerung erfolgt, groß ist gegenüber dem Anfangsbereich (zwischen Koordinaten-Nullpunkt und nutzbarem Bereich für die Aussteuerung), läßt sich die Gate-Steuerspannung als eindeutiges Maß für den Drain-Strom heranziehen.

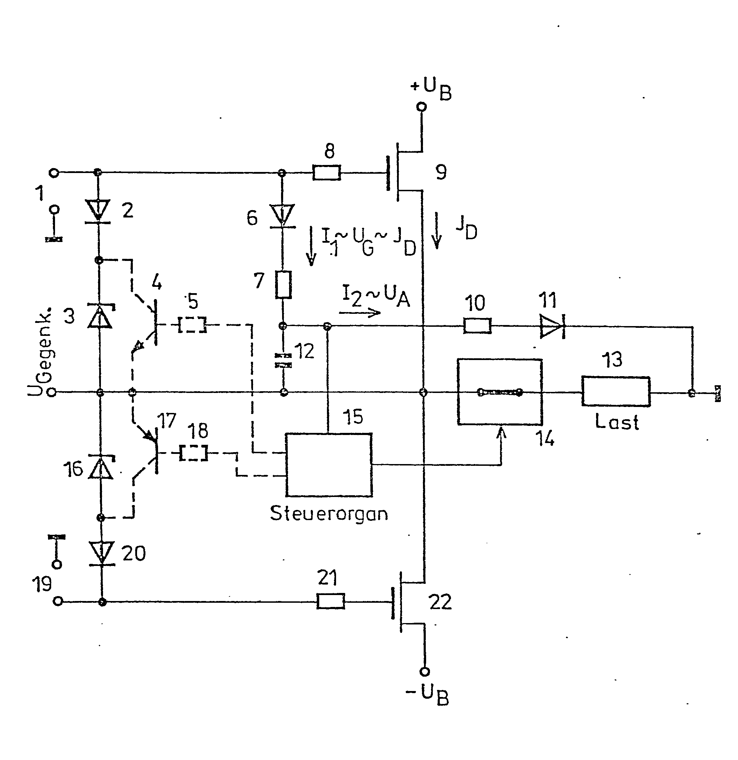

Ein Ausführungsbeispiel der Erfindung, das in der Zeichnung dargestellt ist, wird nun im einzelnen erläutert.

Um sich bei dem Ausführungsbeispiel auf das wesentliche zu beschränken, sind bei der Endstufe die Treiberschaltung sowie die Phasenumkehrstufe weggelassen. Es sind daher zwei gegenphasige Eingänge 1 und 19 vorhanden, über die der Gegentaktendstufe die Ansteuersignale zugeführt werden. Die eigentliche Endstufe enthält im wesentlichen die Endtransistoren 9 und 22, deren Drain-Anschlüsse jeweils an eine positive bzw. negative Betriebsspannung +UB; -UB angeschlossen sind und deren Source-Anschlüsse untereinander verbunden sind und den Ausgang der Endstufe darstellen. Die Steuersignale werden den Gate-Anschlüssen der Transistoren 9, 22 über Schutzwiderstände 8 bzw. 21 zugeführt. Zwischen dem Ausgang der Endstufe und Masse befindet sich in Serie zu einem elektronisch steuerbaren Schalter 14 ein Lastwiderstand 13, der z.B. durch einen Lautsprecher dargestellt werden kann. Die Ausgangsspannung, die an dem Lastwiderstand 13 anliegt, wird außerdem über einen Gegenkopplungsweg gegenphasig auf den in der Zeichnung nicht dargestellten Eingang des Vorverstärkers zurückgeführt.

Die folgenden Ausführungen betreffen speziell den im oberen Teil der Zeichnung dargestellten Verstärkerteil für die positive Halbwelle. Im allgemeinen ist es ausreichend, die Auslöseschaltung für die elektronische Sicherung nur für eine Halbwelle auszubilden. Im ungestörten Betrieb, d.h. wenn der Lastwiderstand 13 einen ausreichenden endlichen Wert darstellt, befindet sich ein Kondensator 12 in einem nahezu ungeladenen Zustand. Dieser Zustand kommt dadurch zustande, daß die dem Drain-Strom $I_D$ proportionale Gate-Spannung $U_G$ des Feldeffekttransistors 9 durch Gleichrichtung mittels eines Gleichrichters 6 einen Ladestrom durch einen Widerstand 7 hervorruft, der durch einen gleichgroßen, entgegengesetzt gerichteten Ladestrom $I_2$, welcher durch Gleichrichtung der Ausgangswechselspannung mittels eines Gleichrichters 11 erzeugt wird und über einen Widerstand 10 fließt, kompensiert wird. Im Falle eines Kurzschlußes bei zu geringem Lastwiderstand sinkt die Ausgangswechselspannung $U_A$ ab. Durch die Abnahme der Gegenkopplungsspannung wird dabei die Ansteuerspannung für den Feldeffekttransistor 9 erhöht. Während als Folge der abnehmenden Ausgangsspannung der Entladestrom $I_2$ abnimmt, nimmt der Ladestrom $I_1$ als Folge der höheren Ansteuerung zu. Die ansteigende Ladespannung am Kondensator 12 speist ein Steuerorgan 15, welches im wesentlichen einen Verstärker und einen Schwellwertschalter enthält. Bei Überschreiten des Schwellwertes ändert sich das Ausgangssignal des Steuerorganes 15 und ein Schaltvorgang wird ausgelöst. In dem dargestellten Ausführungsbeispiel wird dabei der elektronisch steuerbare Schalter 14, der z.B. durch ein Relais gebildet sein kann, geöffnet und dadurch die an den Verstärker angeschlossene Last 13 von dem Ausgang der Transistoren 9 und 22 abgetrennt.

Da aufgrund der Zeitkonstante aus dem Ladewiderstand 7 und
dem Ladekondensator 12 das Auslösen des Schalters 14 erst
mit einer gewissen Verzögerung erfolgt, würde für sehr kurze
Zeit ein hoher Drain-Strom durch die Transistoren 9 und 22
fließen. Um die Ansprechzeit der Ansteuerung für die elektronische Sicherung zu überbrücken, ist eine zusätzliche
Sicherung vorgesehen, die zwar die Ansteuerung der Feldeffekttransistoren 9 und 22 nicht vollständig unterdrückt,
dafür aber unverzögert reagiert. Diese Sicherung besteht jeweils aus antiseriell geschalteten Dioden 2 und 3 für die
Schaltung zur Verarbeitung der positiven Halbwelle und
16 und 20 zur Verarbeitung der negativen Halbwelle. Die
Dioden 3 und 16 sind dabei als Zenerdioden ausgebildet.
Diese Zenerdioden bewirken bei Abnahme der Gegenkopplungsspannung und damit Zunahme der Ansteuerspannung eine Begrenzung der Ansteuerspannung der Feldeffekttransistoren 9
bzw. 22. Die beiden übrigen Dioden 2 und 20 verhindern ein
Leitendwerden der Schaltung bei möglicher gegenphasiger
Ansteuerung. Bis zum Zeitpunkt des Ansprechens der elektronischen Sicherung reicht die beschriebene Maßnahme aus,
eine thermische Überlastung der Endtransistoren zu verhindern.

Anstelle des elektronisch steuerbaren Schalters 14, der die
Last 13 vom Ausgang abtrennt, kann auch ein anderer Weg zum
Schutze der Transistoren beschritten werden. So kann z.B.
durch parallel zu den Zenerdioden 3 und 16 angeordnete Schalttransistoren die Ansteuerung der Feldeffekttransistoren 9
und 22 unterdrückt werden. Diese Lösung ist in der Zeichnung
durch die gestrichelt eingezeichneten Bauelemente 4, 5 und 17,
18 dargestellt. Die Basen der Transistoren 4 und 17 sind über
Basis-Widerstände 5 und 18 mit gegenphasigen Ausgängen des
Steuerorgans 15 verbunden. Beim Ansprechen der elektronischen
Sicherung werden die Transistoren 4 und 17 leitend gesteuert
und schließen damit die Eingangssignale für die Transistoren
9 und 22 kurz.

Patentansprüche

1. Elektronische Sicherung für Endverstärker mit MOS-FET-Endtransistoren, dadurch gekennzeichnet, daß eine von der Gate-Wechselspannung ($U_G$) abhängige Gleichspannung durch Gleichrichtung gewonnen wird, die im Betrieb durch eine entgegengerichtete, durch Gleichrichtung der Ausgangswechselspannung ($U_A$) gewonnene Gleichspannung kompensiert ist und die im Falle eines Kurzschlußes oder einer Verringerung der Kompensationsspannung wirksam wird und über ein Steuerorgan (15) einen elektronisch steuerbaren Schalter (14) auslöst.

2. Elektronische Sicherung nach Anspruch 1, dadurch gekennzeichnet, daß die von der Gate-Wechselspannung ($U_G$) abhängige Gleichspannung durch Aufladen eines Kondensators (12) mit einem der Gate- Wechselspannung ($U_G$) proportionalen gleichgerichteten Strom ($I_1$) und die Kompensationsspannung durch Entladen des Kondensators (12) mit einem der Ausgangsspannung ($U_A$) proportionalen gleichgerichteten Strom ($I_2$) gewonnen werden.

3. Elektronische Sicherung nach Anspruch 2, dadurch gekennzeichnet, daß eine Schaltung zur Begrenzung der Wechselspannung zwischen den Gate-Anschlüssen der MOS-FET-Endtransistoren und einer Bezugsspannung vorgesehen sind, die je Halbwelle aus zwei antiseriell geschalteten Dioden (2, 3; 16, 20) besteht.

4. Elektronische Sicherung nach Anspruch 3, dadurch gekennzeichnet, daß je eine der Dioden eine Zenerdiode (3; 16) ist.

1/1

0025964

0025964

Nummer der Anmeldung

EP 80 10 5517.9

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | FR - A1 - 2 247 014 (SONY CORP.) <br> * Seite 7, Zeile 7 bis Seite 17, Zeile 35; Fig. * <br> --- | 1,2 |
| | US - A - 3 526 845 (D.J. SIKORRA) <br> * Spalte 1, Zeile 71 bis Spalte 3, Zeile 47; Fig. 1 * <br> ---- | 1,3 |

**KLASSIFIKATION DER ANMELDUNG (Int.Cl.³)**

H 03 F 1/52

**RECHERCHIERTE SACHGEBIETE (Int. Cl.³)**

H 03 F 1/00
H 03 F 3/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| Berlin | 07-11-1980 | BORRELLY |

EPA form 1503.1 06.78